# EUROPEAN PATENT SPECIFICATION

(11) **EP 1 059 702 B1**
(45) Date of publication and mention of the grant of the patent: **26.07.2006**
(21) Application number: 00304317.1
(22) Date of filing: 22.05.2000
(51) Int. Cl.: H01R 13/658, H01R 12/16, H05K 9/00, H01R 4/64

(54) **Ground terminal**
Erdungsklemme
Borne de mise à la masse

(30) Priority: 10.06.1999 JP 41521999
(43) Date of publication of application: 13.12.2000
(73) Proprietor: Thomas & Betts International, Inc., Sparks, Nevada 89434 (US)
(72) Inventor: Kumagai, Izuru, Miyaga (JP)
(74) Representative: Howick, Nicholas Keith

(56) References cited:
- EP-A- 0 954 067

## Description

### FIELD OF THE INVENTION:

The present device relates generally to a ground terminal useful for grounding a printed circuit board to a shielding plate or a chassis in order to prevent electromagnetic induction interference and high frequency induction interference.

### BACKGROUND OF THE INVENTION:

Devices are known for grounding a printed circuit board to a shield component. These devices typically include a ground terminal 20', for example, as shown in Figure 6A, which comprises a board portion 1' to be mounted to a ground pattern on a printed circuit board 10' and a spring contact 2' projecting integrally and opposite to the direction of the board portion from one side of the board portion.

However, when accidentally touched by a finger or the like, as shown in Figure 6B, such a ground terminal becomes deformed because of the extending free end of the spring contact. Therefore, there have been problems such as poor contact made between deformed spring contacts and the chassis, and obstacles to housing operations caused by the deformed spring contacts hitched on the chassis when the circuit boards are housed in the chassis.

It is desirable to provide a device which has an object to eliminate the disadvantages described above and provides a ground terminal provided with means for protecting the spring contact from deformation even when accidental external forces are applied thereon.

EP 0 954 067 A2, which forms part of the state of the art under A. 54(3) EPC discloses a grounding terminal comprising, a board portion for mounting to a printed circuit board, and a spring contact projecting integrally and opposite to the direction of the board portion from one side of the board portion, wherein the ground terminal further includes an engaging wall which stands up integrally from the board portion and engages the end portion of the spring contact.

### SUMMARY OF THE INVENTION:

In order to attain this object, the device of the present invention provides a ground terminal comprising:
a board portion having a through hole for accommodating solder for mounting to a ground pattern on a printed circuit board; and
a spring contact projecting integrally and opposite to the direction of said board portion from one side of said board portion,
said ground terminal further including an engaging wall which stands up integrally from said board portion and engages the end portion of said spring contact.

The engaging wall operates as a stop against irregular external forces applied by the touch of fingers or the like on the terminal to protect the terminal from deformation.

### BRIEF DESCRIPTION OF THE DRAWINGS:

Figure 1 is a vertical longitudinal cross-sectional view showing one embodiment of a ground terminal according to the device of the present invention.
Figure 2 is a plan view showing the embodiment of Figure 1.
Figure 3 is a bottom view showing the embodiment of Figure 1.
Figure 4 is a side view showing the embodiment of Figure 1.
Figures 5A and 5B are a cross-sectional view showing the embodiment of Figure 1 under use.
Figures 6A and 6B are cross-sectional views showing a conventional ground terminal of the prior art.

### DETAILED DESCRIPTION OF THE PREFERRED EMBODIMENT:

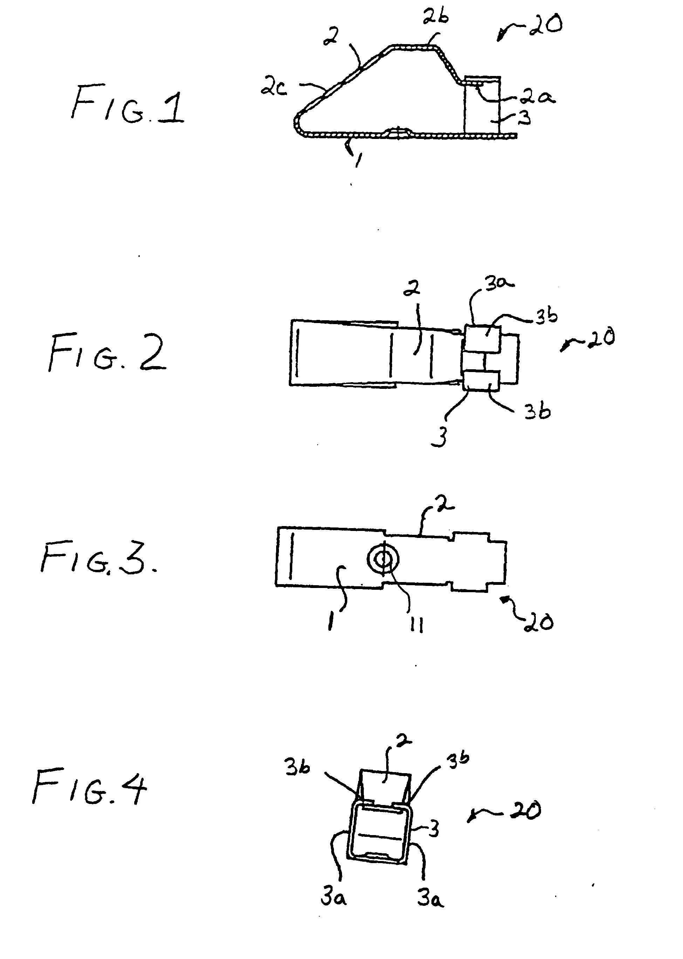

Hereinafter, the device will be explained based on the embodiments shown in the drawings. Figures 1 through 5 show the preferred embodiments in accordance with the device of the present invention.

The ground terminal 20 of the device of the present invention comprises a board portion 1 and a spring contact 2. The board portion 1 may be mounted on a ground pattern (not shown) on a printed circuit board by soldering or other mounting technique. The spring contact 2 projects integrally from and opposite to the direction of the board portion 1 from one side of the board portion. It is contemplated that the underside of the board portion 1 is preferably plated for improved solderability.

The spring contact comprises an end portion 2a, a first body portion 2b which is configured by being integrally connected to the end portion and extends therefrom such that the first body portion 2b is opposed to the board portion 1, and a second body portion 2c which couples the first body portion with the board portion.

The ground terminal 20 is further provided with an engaging wall 3 which stands up integrally from said board portion 1 and engages the end portion 2a of said spring contact. In the embodiment shown in the drawings, the engaging wall 3 specifically operates as a stop wherein the end of the engaging wall 3 holds the end portion 2a of the spring contact. The engaging walls comprise side walls 3a standing up integrally from the opposite sides of said board portion and upper walls 3b extending integrally from the side walls such that the upper walls are opposed to each other, and thus engage the both side of the end portion of the spring contact.

The board portion is soldered to a ground pattern on a printed circuit board. The board portion is provided with through holes 11 such that the soldered joint can be reliable in its strength and in its position accuracy.

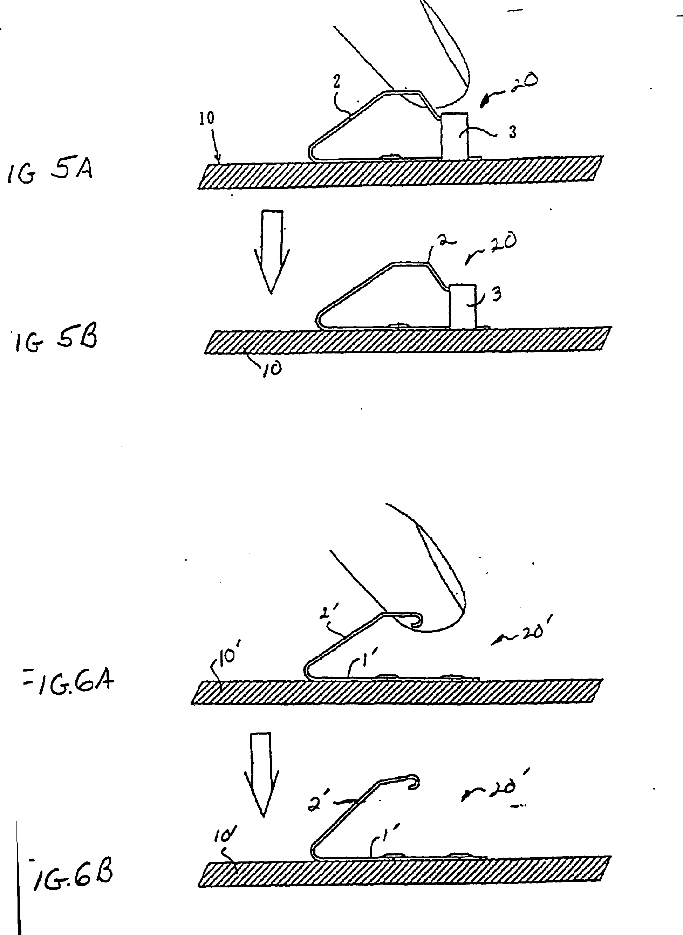

Figures 5A and 5B shows the ground terminal 20 according to the embodiment of the present invention, which is placed on printed circuit board 10. In the illustration, the board portion 1 of the ground terminal 20 is secured to a ground pattern on a printed circuit board by soldering. More specifically, a plurality of the ground terminals 20 are placed on a table. An automatic machine (not shown) absorbs the first body portion of a spring contact by using vacuum and at the same time carries it to a predetermined position in the printed circuit board, and there, by releasing the vacuum absorption, the terminal is placed with the underside thereof down on the circuit board. Then, by passing the circuit board through a soldering bath, the terminal is soldered onto the printed circuit board as well as other circuit elements on the printed circuit board.

After that, the ground terminal 20 is brought into contact with the shielding panel, chassis, frame or the like in order to ground the ground pattern on the printed circuit board thereto. This work is performed by housing the circuit board via the ground terminal of the device into a casing that is provided, for example, with a shielding panel inside thereof. As the board enters the casing, the spring contact is pressed down toward the side of the board portion (inside), so that the end portion of the spring contact may be separated from the engaging wall. This condition can keep the ground terminal in enough contact with the shielding panel.

Under this condition, the part of the spring contact to contact the shielding panel is required to be, even under contact with the shielding panel, higher than the end of the engaging wall, as well as under non-contact condition. Therefore, there is a permissible range within the movable step (oscillation range) of the spring contact.

Although the configuration of the present device has been described above, the following specific advantages can result from the configuration.

The ground terminal according to the device of the present invention is provided with an engaging wall that stands up integrally from the board portion to engage the end portion of the spring contact. Thus, the engaging wall operates as a stopper against irregular external forces applied when a finger or the like touches the ground terminal, to protect the terminal from deformation. Therefore, the ground terminal according to the present device can eliminate disadvantages such as poor contact made between deformed spring contacts and chassis, and obstacles to housing operations caused by the deformed spring contacts hitched on chassis when boards are housed in chassis.

Similar to elements for other printed circuits, since the ground terminal of the present device can be mounted on the circuit board, automatic machines can be used. Accordingly, it is possible to reduce the number of operation processes without any person.

As described above, the use of the ground terminal of the device provides many advantages and so is useful for taking measures against noise and EMI in various electronics equipment, such as displays using CRT, TFT and STN color liquid crystal.

Various changes to the foregoing described and shown structures would now be evident to those skilled in the art. Accordingly, the particularly disclosed scope of the invention is set forth in the following claims.

## Claims

1. A ground terminal comprising:
a board portion (1) having a through hole for accommodating solder for mounting to a ground pattern on a printed circuit board; and
a spring contact (2) projecting integrally and opposite to the direction of said board portion (1) from one side of said board portion (1),
said ground terminal further including an engaging wall (3) which stands up integrally from said board portion (1) and engages the end portion of said spring contact (2).

2. The ground terminal according to claim 1 wherein said engaging wall (3) defines a stop wherein the end of said engaging wall (3) holds the end portion of said spring contact (2).

3. The ground terminal according to claim 1 wherein said engaging wall (3) stands up integrally from the opposite sides of said board portion (1) and engages the both sides of the end portion of said spring contact (2).

## Patentansprüche

1. Eine Erdungsklemme mit:
einem Tafelabschnitt (1) mit einem Durchgangsloch zum Aufnehmen von Lot zum Befestigen an einem Erdungsschema auf einer Leiterplatte und
einem entgegengesetzt zu der Richtung des Tafelabschnitts (1) von einer Seite des Tafelabschnitts (1) integral vorstehenden Federkontakt (2),
wobei die Erdungsklemme weiter eine anliegende Wand (3) aufweist, die von dem Tafelabschnitt (1) integral aufsteht und an dem Endabschnitt des Federkontaktes (2) anliegt.

2. Die Erdungsklemme nach Anspruch 1, wobei die anliegende Wand (3) einen Anschlag bildet, wobei das Ende der anliegenden Wand (3) den Endabschnitt des Federkontakts (2) hält.

3. Die Erdungsklemme nach Anspruch 1, wobei die anliegende Wand (3) von den einander entgegengesetzten Seiten des Tafelabschnitts (1) integral hochsteht und die beiden Seiten des Endabschnittes des Federkontakts (2) erfaßt.

## Revendications

1. Borne de mise à la masse comprenant :
une partie carte (1) présentant un trou traversant destiné à recevoir une soudure en vue d'un raccord à un motif de mise à la masse se trouvant sur une carte à circuits imprimés ; et
un contact à ressort (2) d'un seul tenant, faisant saillie en s'écartant de la direction de ladite partie carte (1) à partir d'un côté de ladite partie carte (1),
ladite borne de mise à la masse comprenant, en outre, une paroi de prise (3) qui s'élève verticalement d'un seul tenant à partir de ladite partie carte (1), et vient en prise avec la partie d'extrémité dudit contact à ressort (2).

2. Borne de mise à la masse selon la revendication 1, dans laquelle ladite paroi de prise (3) définit une butée, l'extrémité de ladite paroi de prise (3) maintenant la partie d'extrémité dudit contact à ressort (2).

3. Borne de mise à la masse selon la revendication 1, dans laquelle ladite paroi de prise (3) s'élève verticalement d'un seul tenant à partir des côtés opposés de ladite partie carte (1), et vient en prise avec les deux côtés de la partie d'extrémité dudit contact à ressort (2).
